# EUROPÄISCHE PATENTSCHRIFT

(11) **EP 1 035 638 B1**
(45) Veröffentlichungstag und Bekanntmachung des Hinweises auf die Patenterteilung: **21.09.2011**
(21) Anmeldenummer: 00103187.1
(22) Anmeldetag: 17.02.2000
(51) Int. Cl.: H02M 5/458, H02J 3/38, H02M 7/797

(54) **Verfahren und Schaltungsanordnung zur Abbildung der Netzspannung bei rückspeisefähigen Versorgungsgeräten**
Method and circuit arrangement for imaging the network voltage near power supply devices capable of feeding back energy
Méthode et arrangement de circuit pour constituer une image de la tension de réseau près d'appareils d'alimentation avec récupération d'énergie

(30) Priorität: 05.03.1999 DE 19909706
(43) Veröffentlichungstag der Anmeldung: 13.09.2000
(73) Patentinhaber: Dr. Johannes Heidenhain GmbH, 83292 Traunreut (DE)
(72) Erfinder: Huber, Norbert, 83317 Teisendorf (DE)

(56) Entgegenhaltungen:
- WO-A-98/34335

## Beschreibung

Die Erfindung betrifft ein Verfahren zur Abbildung der Netzspannung bei rückspeisefähigen Versorgungsgeräten gemäss den Merkmalen des Anspruchs 1 und eine Schaltungsanordnung zur Durchführung des Verfahrens gemäss den Merkmalen des Anspruchs 8.

Aus dem Stand der Technik sind Umrichter für Elektromotoren von Werkzeugmaschinen bekannt, die bei einem Abbremsen der Elektromotoren die dabei entstehende Energie in das Versorgungsnetz zurückspeisen. Ein Beispiel für so eine Vorrichtung liefert die Druckschrift WO 98/34335. Für die Rückspeisung der Energie in das Netz werden die Elektromotoren im Generatorbetrieb betrieben. Die von den Elektromotoren ausgegebene Spannung wird zunächst gleichgerichtet und anschliessend in eine Spannung umgewandelt, die die gleiche Frequenz und Phasenlage wie die Netzspannung aufweist. Bei einem dreiphasigen Drehstromsystem müssen mindestens zwei derartige Spannungen für eine Rückspeisung bestimmt werden, die dritte Spannung kann dann aus den beiden bekannten errechnet werden. Die derart bestimmten Spannungen werden als Netzabbild bezeichnet.

Um den Verdrahtungsaufwand möglichst klein zu halten, ist es von Vorteil, die aus dem Netz benötigten Steuersignale zur Bestimmung des Netzabbilds nach den Kommutierungsdrosseln abzugreifen, an denen ein zur Netzspannung proportionales, pulsweitenmoduliertes Signal anliegt. Da an dieser Stelle die Netzspannung durch die Pulsweitenmodulation moduliert ist, wird ein Tiefpassfilter benötigt, um die Netzspannung zu demodulieren. Dieser Filter soll die Phase möglichst wenig drehen, die Pulsweitenmodulation aber möglichst gut demodulieren. Hierzu wird vorteilhaft ein Tiefpassfilter mit einer Grenzfrequenz von ca. 2 kHz verwendet.

Ein Nachteil eines solchen Filters ist, dass Oberwellen der Netzfrequenz nicht unterdrückt werden. Die Folge davon ist, daß bei Anschluß an ein Netz mit relativ hohem Innenwiderstand (z.B. durch Verwendung eines Netztransformators zur Anpassung der Netzspannung) leicht Schwingneigung auftreten kann. Dies gilt besonders beim Rückspeisen, da hierbei eine Mitkopplung bezüglich der Oberwellen eintreten kann.

Dieser Nachteil wird bei Verwendung von sogenannten -90-Grad-Filtern vermieden. Einem derartigen Filter werden zwei von drei Netzspannungen eines Drehstromnetzes zugeleitet, in einem vorgeschalteten Subtrahierer die Differenz aus den beiden gebildet und diese Differenz durch den Filter um -90 Winkelgrad gedreht. Dadurch wird ein Abbild der dritten Phase erzeugt. Ein -90-Grad-Filter ist ein Tiefpassfilter mit sehr niedriger Grenzfrequenz (z.B. 2 Hz), der bei 50 Hz eine Phasendrehung von nahezu -90 Grad erzeugt. Die exakte Drehung um -90 Grad wird durch einen zweiten, in Reihe geschalteten Filter mit ca. 1,25 kHz Grenzfrequenz erreicht. Wird keine exakte Drehung um -90 Grad benötigt, kann der zweite Filter auch entfallen. Diese Schaltung hat den Vorteil, daß aufgrund der niedrigen Grenzfrequenz alle Oberwellen aus der Netzfrequenz gut bedämpft werden und somit eine Sinusspannung mit sehr kleinem Klirrgrad zur Verfügung steht.

Nachteil dieser, ebenfalls aus dem Stand der Technik bekannten Schaltungsanordnung ist jedoch, dass beim Ausfall einer Netzspannung an den Kommutierungsdrosseln die Bestimmung des Netzabbilds fehlerhaft ist, da die beiden anderen Netzspannungen aus der ausgefallenen Netzspannung ermittelt werden. Die Folge davon ist, dass bei Ausfall einer der drei Netzspannungen der Phasenstrom und die Zwischenkreisspannung durch die Fehlansteuerung sehr schnell extreme Werte aufweisen.

Die Aufgabe der vorliegenden Erfindung ist es daher, ein Verfahren zur Abbildung der Netzspannung anzugeben, bei dem sowohl eine Schwingneigung aufgrund von Mitkopplung der Oberwellen vermieden wird als auch bei Ausfall einer Netzspannungsphase keine unzulässig hohen Ströme entstehen. Dieses Verfahren soll weiterhin durch eine möglichst einfache und preisgünstige Schaltungsanordnung realisiert werden.

Diese Aufgabe wird durch ein Verfahren gemäss den Merkmalen des Anspruchs 1 und durch eine Schaltungsanordnung gemäss den Merkmalen des Anspruchs 8 gelöst.

Vorteilhafte Ausführungsformen der erfindungsgemässen Anordnung und des erfindungsgemässen Verfahrens ergeben sich aus den Merkmalen der jeweils abhängigen Ansprüche.

Das erfindungsgemässe Verfahren weist den Vorteil auf, dass automatisch zwischen den beiden bekannten Verfahren zur Abbildung der Netzspannung umgeschaltet wird. Treten keine unzulässigen Werte für Phasenspannungen und -ströme auf, wird das Abbild der Netzspannungen mittels der -90-Grad-Filter in bekannter Art und Weise bestimmt. Sobald eine Netzspannung ausfällt, würden aber durch die -90-Grad-Filter unzulässige Phasenströme eingestellt werden. Sobald die Differenz der Ausgangsspannungen des -90-Grad-Filters und des Filters höherer Grenzfrequenz im ersten und zweiten Pfade grösser als die Schwellspannungen der Dioden des Verknüpfungsnetzwerks werden, übernehmen automatisch die Tiefpässe mit höherer Grenzfrequenz im zweiten Pfad die Regelung der Phasenspannungen. Dies wird dadurch erreicht, dass die -90-Grad-Filter hochohmig an den Summationspunkt der Ausgangssignale des ersten und zweiten Pfades angekoppelt sind, die Filter des ersten Pfades aber über eine Diodenreihenschaltung.

Somit wird das Abbild der Netzspannungen im Bereich zulässiger Werte für die Zwischenkreisspannung oder für die Phasenströme durch die -90-Grad-Filter ermittelt. Sobald aber die Differenz der Ausgangssignale von erstem und zweitem Pfad einen bestimmten Grenzwert übersteigt, der durch Anzahl und Schwellspannung der Dioden eingestellt wird, wird das Netzabbild durch die Tiefpassfilter höherer Grenzfrequenz bestimmt. Durch die Verwendung der Tiefpassfilter höherer Grenzfrequenz zur Ermittlung des Netzabbilds können dann unzulässig hohe Werte der Zwischenkreisspannung und der Phasenströme verhindert werden.

Weitere vorteilhafte Ausgestaltungen sind den jeweils abhängigen Ansprüchen und der Beschreibung zu entnehmen.

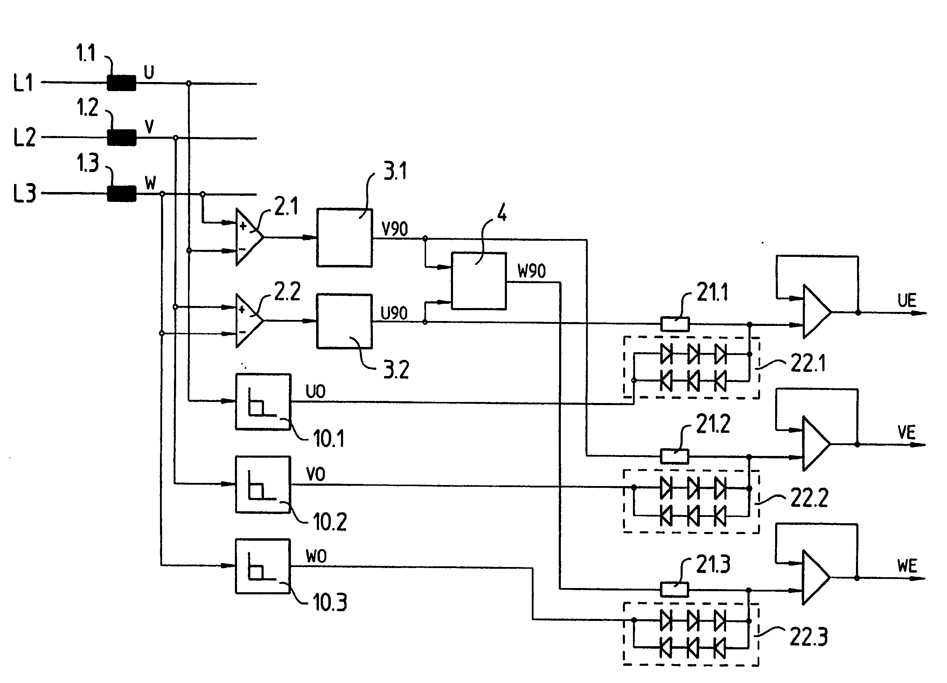

Einzelheiten der Erfindung werden im folgenden anhand der in der Zeichnung dargestellten Ausführungsform näher erläutert.

Die einzige Figur zeigt eine mögliche erfindungsgemässe Schaltungsanordnung.

Im folgenden Ausführungsbeispiel wird von einem dreiphasigen Drehstromsystem ausgegangen, an das ein rückspeisefähiges Versorgungsgerät für einen Umrichter einer Werkzeugmaschine angeschlossen ist. Durch den Umrichter werden Elektromotoren einer Werkzeugmaschine mit elektrischer Energie versorgt. Sobald die Elektromotoren gebremst werden, wird Energie in das Versorgungsnetz zurückgespeist, so dass diese nicht zur Erwärmung des Elektromotors oder eines Bremswiderstands im Umrichter führt. Zur Rückspeisung der kinetischen Energie des Elektromotors wird dieser durch die daran angeschlossene Steuerung im Generatorbetrieb betrieben und die kinetische in elektrische Energie gewandelt. Diese elektrische Energie wird über den Zwischenkreis des Umrichters wieder ins Netz zurückgespeist. Für diese Rückspeisung müssen Frequenz und Phaselage der Netzspannungen durch das rückspeisefähige Versorgungsgerät eingestellt werden. Dafür muss Frequenz und Phasenlage der Netzspannungen in Form eines Netzabbilds ermittelt werden.

Dies erfolgt erfindungsgemäss parallel in zwei Pfaden, wie die Figur zeigt. In einem ersten Pfad werden je zwei unterschiedliche, zu den drei Netzspannungen L1, L2 und L3 proportionale, aber pulsbreitenmodulierte Signale an den Kommutierungsdrosseln 1.1, 1.2 und 1.3 abgegriffen und je einem Subtrahierer 2.1 und 2.2 zugeleitet, der die Differenz aus den beiden zugeleiteten Signalspannungen U, V und/oder W bildet. Die Ausgangssignale der Subtrahierer 2.1 und 2.2 werden jeweils einem -90-Grad-Filter 3.1 und 3.2 zugeleitet, der eine Grenzfrequenz im Bereich von ca. 1 Hz - 10 Hz aufweist. Durch diese -90-Grad-Filter 3.1 und 3.2 werden die Differenzspannungen tiefpassgefiltert und die Phasenlagen um -90 Winkelgrad gedreht, so daß die Ausgangssignale V90 und U90 erzeugt werden. Aus diesen beiden Ausgangssignalen V90 und U90 wird in einem weiteren Subtrahierer 4 durch Differenzbildung das noch fehlende dritte Ausgangssignal W90 erzeugt.

Gleichzeitig wird in einem zweiten, zum ersten parallelen Pfad jede der drei pulsbreitenmodulierten, zu den Netzspannungen L1, L2 und L3 proportionalen Signalspannungen U, V und W in einem Tiefpassfilter 10.1, 10.2 und 10.3 mit einer Grenzfrequenz im Bereich von ca. 1 - 3 kHz tiefpassgefiltert. Dadurch werden die Signalspannungen U, V und W demoduliert und es wird auch in diesem zweiten Pfad ein Abbild der Netzspannungen erzeugt. Auch im zweiten Pfad kann alternativ, wie im ersten Pfad, eine der drei Signalspannungen aus der Differenz der beiden anderen ermittelt werden. Dadurch wird an Stelle eines dritten Tiefpassfilters höherer Grenzfrequenz ein Subtrahierer benötigt.

Die Ausgangssignale V90 und U90 der -90-Grad-Filter 3.1 und 3.2 sowie das Ausgangssignal W90 des Subtrahierers 4 werden über Widerstände 21.1, 21.2 und 21.3 Verstärkern zugeleitet. Die Ausgangssignale der Tiefpässe 10.1, 10.2 und 10.3 höherer Grenzfrequenz werden über Diodennetzwerke 22.1, 22.2 und 22.3 den gleichen Eingängen der Verstärkern zugeleitet.

Durch diese spezielle Zusammenschaltung der Ausgangssignale V90, U90 und W90 sowie U0, V0 und W0 der parallel geschalteten -90-Grad-Filter 3.1, 3.2, des Subtrahierers 4 und der Filter 10.1, 10.2 und 10.3 höherer Grenzfrequenz in einem Verknüpfungsnetzwerk erfolgt die Regelung der Zwischenkreisspannung ausschliesslich durch die -90-Grad-Filter 3.1 und 3.2, wenn die Differenz zwischen den Ausgangssignalen V90, U90 und W90 der -90-Grad-Filter 3.1, 3.2 und des Subtrahierers 4 sowie der Filter 10.1, 10.2 und 10.3 mit höherer Grenzfrequenz gering ist. Die Dioden 22.1, 22.2 und 22.3, über die die Filter 10.1, 10.2 und 10.3 höherer Grenzfrequenz mit den Verstärkern verbunden sind, sperren in diesem Betriebsfall. Dadurch, dass die -90-Grad-Filter 3.1 und 3.2 Oberwellen stark bedämpfen, kann eine Schwingneigung verhindert werden.

Steigt aber die Differenz zwischen den Ausgangssignale V90, U90 und W90 der -90-Grad-Filter 3.1, 3.2 sowie des Subtrahierers 4 und den Ausgangssignalen U0, V0 und W0 der Filter 10.1, 10.2 und 10.3 höherer Grenzfrequenz wesentlich an, z.B. durch Ausfall einer Netzspannung, werden die Schwellspannungen der Dioden 22.1, 22.2 und 22.3 des Verknüpfungsnetzwerks überschritten. Sobald die Schwellspannungen der Dioden 22.1, 22.2 und 22.3, über die die Ausgangssignale U0, V0 und W0 der Filter 10.1, 10.2 und 10.3 höherer Grenzfrequenz mit den Verstärkern verbunden werden, überschritten sind, werden die Verstärker im wesentlichen durch die Ausgangssignale U0, V0 und W0 der Filter 10.1, 10.2 und 10.3 höherer Grenzfrequenz angesteuert. Da die Ausgangssignale V90, U90 und W90 der -90-Grad-Filter jeweils über einen Widerstand 21.1, 21.2 und 21.3 hochohmig mit den Verstärkereingängen verbunden sind, werden die Eingangssignale der Verstärker durch die Ausgangssignal U0, V0 und W0 der Filter 10.1, 10.2 und 10.3 höherer Grenzfrequenz bestimmt, da diese nach dem Durchschalten der Dioden niederohmig mit den Verstärkereingängen verbunden sind.

Dadurch wird das Netzabbild für kleine Differenzen der Ausgangsspannungen U0, V0 und W0 sowie V90, U90 und W90 der Filter 3.1, 3.2 und 10.1, 10.2 sowie 10.3 in beiden Pfaden durch die -90-Grad-Filter 3.1 und 3.2, für grosse Differenzen der Ausgangsspannungen U0, V0 und W0 sowie V90, U90 und W90 der Filter 3.1, 3.2 und 10.1, 10.2 sowie 10.3 in beiden Pfaden durch die Filter 10.1, 10.2 und 10.3 höherer Grenzfrequenz bestimmt. Bei grossen Differenzen der Ausgangsspannungen U0, V0 und W0 sowie V90, U90 und W90 der Filter 3.1, 3.2 und 10.1, 10.2 sowie 10.3 in beiden Pfaden wird davon ausgegangen, dass eine Phase der Netzspannung ausgefallen ist und die -90-Grad-Filter 3.1 und 3.2 kein korrektes Netzabbild mehr liefern. Daher wird das Netzabbild automatisch durch die Filter 10.1, 10.2 und 10.3 höherer Grenzfrequenz bestimmt, um zu grosse Werte für Zwischenkreisspannung und Phasenstrom schnellstmöglich zu vermeiden.

In der Regel ist auch eine Schaltung zur Überwachung der Netzspannungen vorgesehen, die aber meist erst etwas später anspricht und dann beispielsweise das Versorgungsgerät abschaltet.

Durch die den -90-Grad-Filtern 3.1 und 3.2 und dem Subtrahierer 4 nachgeschalteten Widerstände 21.1, 21.2 und 21.3 und die den Filtern 10.1, 10.2 und 10.3 höherer Grenzfrequenz nachgeschalteten Dioden 22.1, 22.2 und 22.3 wird somit eine Auswahlschaltung realisiert, die abhängig von der Differenz der Ausgangssignale der beiden Pfade die Ausgangssignale eines Pfades zur Regelung auswählt. Dabei werden jeweils die Ausgangssignale gleicher Phasenlage in unterschiedlichen Pfaden miteinander verglichen, also U0 mit U90, V0 mit V90 und W0 mit W90.

Als Filter 10.1, 10.2 und 10.3 höherer Grenzfrequenz werden bevorzugt Filter dritter Ordnung mit einer Grenzfrequenz zwischen 1 kHz und 3 kHz ausgewählt. Die -90-Grad-Filter 3.1 und 3.2 weisen eine Grenzfrequenz von ca. 1 - 10 Hz auf und drehen das Ausgangssignal V90 und U90 um ca. -90 Grad relativ zum Eingangssignal. Alternativ zum Subtrahierer 4 kann auch ein zusätzlicher Subtrahierer und -90-Grad-Filter zur Erzeugung des dritten Ausgangssignals W90 vorgesehen sein, der in Analogie zu den vorhandenen Subtrahierern 2.1 und 2.2 bzw. -90-Grad-Fitern 3.1 und 3.2 zu verschalten ist.

Das erfindungsgemässe Verfahren und die erfindungsgemässe Schaftungsanordnung kann überall dort angewendet werden, wo Energie eines Elektromotors in ein Versorgungsnetz zurückgespeist werden soll und dafür die Phase dem Netz nachgeführt werden muss.

## Patentansprüche

1. Verfahren zur Abbildung der Netzspannungen (L1, L2, L3) eines mehrphasigen Wechselspannungsnetzes anhand von pulsweitenmodulierten Steuersignalen (U, V, W) von rückspeisefähigen Versorgungsgeräten, wobei die Steuersignale (U, V, W) Signalspannungen sind, insbesondere geeignet für Umrichter von Elektromotoren, wobei
a) in einem ersten Pfad (2.1, 2.2, 3.1, 3.2, 4) Differenzsignale aus je zwei pulsweitenmodulierten Steuersignalen (U, V, W) gebildet, tiefpassgefiltert und dabei um -90 Winkelgrad gedreht werden, wodurch Ausgangssignale (V90, U90, W90) gebildet werden,
b) gleichzeitig werden parallel dazu in einem zweiten Pfad (10.1, 10.2, 10.3) die pulsweitenmodulierten Steuersignale (U, V, W) tiefpassgefiltert, wodurch weitere Ausgangssignale (U0, V0, W0) gebildet werden, und
c) anschließend wird aus den beiden für jede Netzspannung erzeugten Abbildern (U0, V0, W0, U90, V90, W90) mittels einer Auswahlschaltung in Form eines Verknüpfungsnetzwerks (21.1, 21.2, 21.3, 22.1, 22.2, 22.3) für jede Netzspannung ein Abbild (U0, V0, W0, U90, V90, W90) zur Weiterleitung ausgewählt, was abhängig von der Differenz der zwischen den beiden für jede Netzspannung vorliegenden Abbildern (U0, V0, W0, U90, V90, W90) erfolgt, wobei für kleine Differenzen das Ausgangssignal des ersten Pfads (2.1, 2.2, 3.1, 3.2, 4) weitergeleitet wird und sonst das Ausgangssignal des zweiten Pfads (10.1, 10.2, 10.3) weitergeleitet wird.

2. Verfahren nach Anspruch 1, wobei das Wechselspannungsnetz (L1, L2, L3) dreiphasig ist.

3. Verfahren nach Anspruch 1 oder 2, wobei die Tiefpassfilterung im ersten Pfad (2.1, 2.2, 3.1, 3.2, 4) mit einer Grenzfrequenz im Bereich von ca. 1 - 10 Hz und gleichzeitig damit eine Phasendrehung um ca. -90 Winkelgrad erfolgt.

4. Verfahren nach Anspruch 1, wobei die Tiefpassfilterung im zweiten Pfad (10.1, 10.2, 10.3) mit einer Grenzfrequenz von ca. 1 - 3 kHz erfolgt, damit sich eine möglichst geringe phasendrehung ergibt.

5. Verfahren nach Anspruch 1, wobei eine letzte noch fehlende Signalspannung (W90) durch Berechnung der Differenz der bereits bestimmten Signalspannungen (V90, U90) ermittelt wird.

6. Schaltungsanordnung zur Abbildung der Netzspannungen (L1, L2, L3) eines mehrphasigen Wechseispannungsnetzes anhand von pulsweitenmodulierten Steuersignalen (U, V, W) von rückspeisefähigen Versorgungsgeräten, wobei die Steuersignale (U, V, W) Signalspannungen sind, insbesondere geeignet für Umrichter von Elektromotoren, wobei
a) in einem ersten Pfad (2.1, 2.2, 3.1, 3.2, 4) Subtrahierer (2.1, 2.2) zur Bildung der Differenzsignale aus jeweils zwei pulsweitenmodulierten Steuersignalen (U, V, W) angeordnet sind, deren Ausgangssignale ersten Tiefpässen (3.1, 3.2) mit einer Phasendrehung um ca. - 90 winkel - grad zugeleitet werden, wodurch Ausgangssignale (V90, U90, W90) gebildet werden,
b) in einem zweiten Pfad (10.1, 10.2, 10.3) zweite Tiefpässe (10.1, 10.2, 10.3) höherer Grenzfrequenz angeordnet sind, denen pulsweitenmodulierte Steuersignale (U, V, W) zugeleitet werden, wodurch weitere Ausgangssignale (U0, V0, W0) gebildet werden,
c) eine Auswahlschaltung in Form eines Verknüpfungsnetzwerks (21.1, 21.2, 21.3, 22.1, 22.2, 22.3) vorgesehen ist, welchem die Ausgangssignale (U0, V0, W0, U90, V90, W90) des ersten und zweiten Pfades zugeleitet werden und das abhängig von der Differenz zwischen den Ausgangssignalen (U0, V0, W0, U90, V90, W90) der beiden Pfade die Ausgangssignale eines Pfades weiterleitet, wobei für kleine Differenzen das Ausgangssignal des ersten Pfads (2.1, 2.2, 3.1, 3.2, 4) weitergeleitet wird und sonst das Ausgangssignal des zweiten Pfads (10.1, 10.2, 10.3) weitergeleitet wird.

7. Schaltungsanordnung nach Anspruch 6, wobei der erste Tiefpass (3.1, 3.2) ein Tiefpass erster oder zweiter Ordnung ist.

8. Schaltungsanordnung nach Anspruch 6 oder 7, wobei der zweite Tiefpass (10.1, 10.2, 10.3) eine Grenzfrequenz über der Frequenz der Netzspannung aufweist, um eine möglichst geringe Phasendrehung zu erhalten.

9. Schaltungsanordnung nach Anspruch 6, wobei zum ersten Tiefpassfilter (3.1, 3.2) im ersten Pfad (2.1, 2.2, 3.1, 3.2, 4) ein weiteres Tiefpassfilter in Reihe geschaltet ist, das eine Grenzfrequenz von ca. 0,5 - 2 kHz aufweist.

10. Schaltungsanordnung nach Anspruch 6, wobei im Verknüpfungsnetzwerk (21.1, 21.2, 21.3, 22.1, 22.2, 22.3) das Ausgangssignal (U90, V90, W90) des ersten Pfads (2.1, 2.2, 3.1, 3.2, 4) einem Widerstand (21.1, 21.2, 21.3) und anschließend einem Summationspunkt zugeleitet wird und das Ausgangssignal des zweiten Pfads (10.1, 10.2, 10.3) einem Diodennetzwerk (22.1, 22.2, 22.3) und anschließend dem Summationspunkt zugeleitet wird.

11. Schaltungsanordnung nach Anspruch 10, wobei das Diodennetzwerk (22.1, 22.2, 22.3) zwei parallel geschaltete Gruppen in Reihe geschalteter Dioden aufweist, wodurch, abhängig von der Anzahl der in Reihe geschalteter Dioden, Signale mit betragsmäßig kleiner Amplitude nicht zum Summationspunkt weitergeleitet werden.

## Claims

1. Method for mapping the mains voltages (L1, L2, L3) of a multi-phase AC voltage mains on the basis of pulse-width modulated control signals (U, V, W) of regenerative supply devices, wherein the control signals (U, V, W) are signal voltages, particularly suitable for converters of electric motors, wherein
a) in a first path (2.1, 2.2, 3.1, 3.2, 4), differential signals are each formed from two pulse-width modulated control signals (U, V, W), low pass filtered and rotated through -90 degrees in the process, as a result of which output signals (V90, U90, W90) are formed,
b) at the same time, parallel thereto in a second path (10.1, 10.2, 10.3), the pulse-width modulated control signals (U, V, W) are low pass filtered, as a result of which further output signals (U0, V0, W0) are formed, and
c) subsequently, for each mains voltage, an image (U0, V0, W0, U90, V90, W90) for forwarding is selected from the two images (U0, V0, W0, U90, V90, W90) generated for each mains voltage, by means of a selection circuit in the form of a logic network (21.1, 21.2, 21.3, 22.1, 22.2, 22.3), which takes place in dependence on the difference between the two images (U0, V0, W0, U90, V90, W90) present for each mains voltage, wherein for small differences, the output signal of the first path (2.1, 2.2, 3.1, 3.2, 4) is forwarded and otherwise the output signal of the second path (10.1, 10.2, 10.3) is forwarded.

2. Method according to Claim 1, wherein the AC voltage mains (L1, L2, L3) is three phase.

3. Method according to Claim 1 or 2, wherein the low pass filtering in the first path (2.1, 2.2, 3.1, 3.2, 4) takes place with a cut-off frequency in the range of approx. 1-10Hz and a phase rotation by approx. -90 degrees takes place at the same time.

4. Method according to Claim 1, wherein the low pass filtering in the second path (10.1, 10.2. 10.3) takes place with a cut-off frequency of approx. 1-3 kHz so that a phase rotation which is as low as possible results.

5. Method according to Claim 1, wherein a last, still missing signal voltage (W90) is determined by calculating the difference between the already determined signal voltages (V90, U90).

6. Circuit arrangement for mapping the mains voltages (L1, L2, L3) of a multi-phase AC voltage mains on the basis of pulse-width modulated control signals (U, V, W) of regenerative supply devices, wherein the control signals (U, V, W) are signal voltages, particularly suitable for converters of electric motors, wherein
a) subtractors (2.1, 2.2) for forming the differential signals from two pulse-width modulated control signals (U, V, W) in each case are arranged in a first path (2.1, 2.2, 3.1, 3.2, 4), the output signals of which subtractors are forwarded to first low pass filters (3.1, 3.2) with a phase rotation of approx -90 degrees, as a result of which output signals (V90, U90, W90) are formed,
b) in a second path (10.1, 10.2, 10.3) second low pass filters (10.1, 10.2, 10.3) are arranged, to which the pulse-width modulated control signals (U, V, W) are forwarded, as a result of which further output signals (U0, V0, W0) are formed,
c) a selection circuit in the form of a logic network (21.1, 21.2, 21.3, 22.1, 22.2, 22.3) is provided, to which logic network the output signals (U0, V0, W0, U90, V90, W90) of the first and second path are forwarded and which logic network forwards the output signals of one path in dependence on the difference between the output signals (U0, V0, W0, U90, V90, W90) of the two paths, wherein for small differences, the output signal of the first path (2.1, 2.2, 3.1, 3.2, 4) is forwarded and otherwise the output signal of the second path (10.1, 10.2, 10.3) is forwarded.

7. Circuit arrangement according to Claim 6, wherein the first low pass filter (3.1, 3.2) is a first order or second order low pass filter.

8. Circuit arrangement according to Claim 6 or 7, wherein the second low pass filter (10.1, 10.2. 10.3) has a cut-off frequency above the frequency of the mains voltage, in order to obtain a phase rotation which is as low as possible.

9. Circuit arrangement according to Claim 6, wherein a further low pass filter, which has a cut-off frequency of approx. 0.5-2 kHz, is connected in series in the first path (2.1, 2.2, 3.1, 3.2, 4) to the first low pass filter (3.1, 3.2).

10. Circuit arrangement according to Claim 6, wherein, in the logic network (21.1. 21.2, 21.3, 22.1, 22.2, 22.3), the output signal (U90, V90, W90) of the first path (2.1, 2.2, 3.1, 3.2, 4) is supplied to a resistor (21.1, 21.2. 21.3) and subsequently to a summation point and the output signal of the second path (10.1, 10.2, 10.3) is supplied to a diode network (22.1, 22.2, 22.3) and subsequently to the summation point.

11. Circuit arrangement according to Claim 10, wherein the diode network (22.1, 22.2, 22.3) has two parallel-connected groups of diodes connected in series, as a result of which, in dependence on the number of diodes connected in series, signals with a smaller amplitude are not forwarded to the summation point.

## Revendications

1. Procédé pour reproduire des tensions de réseau (L1, L2, L3) d'un réseau de tension alternative polyphasé de tension alternative à l'aide de signaux de commande (U, V, W) modulés en largeur d'impulsion d'appareils d'alimentation aptes pour une alimentation retour, les signaux de commande (U, V, W) étant des tensions de signal, appropriés en particulier pour des convertisseurs de moteurs électriques,
a) des signaux différentiels étant formés chacun dans un premier chemin (2.1, 2.2, 3.1, 3.2, 4) de deux signaux de commande (U, V, W) modulés en largeur d'impulsion, subissant un filtrage passe-bas et tournés alors d'un angle de -90°, de sorte que des signaux de sortie (V90, U90, W90) sont formés,
b) les signaux de commande (U, V, W) modulés en largeur d'impulsion subissent un filtrage passe-bas simultanément en en parallèle dans un second chemin (10.1, 10.2, 10.3), de sorte que d'autres signaux de sortie (U0, V0, W0) sont formés, et
c) ensuite, à partir des deux images (U0, V0, W0, U90, V90, W90) générées pour chaque tension de réseau, on sélectionne une image (U0, V0, W0, U90, V90, W90) au moyen d'un circuit de sélection sous forme d'un réseau de combinaison (21.1, 21.2, 21.3, 22.1, 22.2, 22.3) pour chaque tension de réseau une image (U0, V0, W0, U90, V90, W90) pour la transmission, ce qui s'effectue en fonction de la différence entre les deux images (U0, V0, W0, U90, V90, W90) présentes pour chaque tension de réseau, sachant que, pour de petites différences, le signal de sortie du premier chemin (2.1, 2.2, 3.1, 3.2, 4) est transmis et sinon le signal de sortie du second chemin (10.1, 10.2, 10.3) est transmis.

2. Procédé selon la revendication 1, le réseau de tension alternative (L1, L2, L3) étant triphasé.

3. Procédé selon la revendication 1 ou 2, le filtrage passe-bas dans le premier chemin (2.1, 2.2, 3.1, 3.2, 4) s'effectuant avec une fréquence limite de l'ordre d'environ 1-10 Hz et une rotation de phase d'un angle d'environ -90 degrés s'effectuant donc simultanément.

4. Procédé selon la revendication 1, le filtrage passe-bas dans le second chemin (10.1, 10.2, 10.3) s'effectuant avec une fréquence limite d'environ 1-3 kHz, pour qu'on obtienne une rotation de phase la plus faible possible.

5. Procédé selon la revendication 1, une dernière tension de signal (W90) faisant encore défaut étant déterminée par calcul de la différence des tensions de signal (V90, U90) déjà déterminées.

6. Configuration de circuit pour reproduire les tensions de réseau (L1, L2, L3) d'un réseau de tension alternative polyphasé de tension alternative à l'aide de signaux de commande (U, V, W) modulés en largeur d'impulsion d'appareils d'alimentation aptes pour une alimentation retour, les signaux de commande (U, V, W) étant des tensions de signal, appropriés en particulier pour des convertisseurs de moteurs électriques,
a) des soustracteurs (2.1, 2.2) étant disposés dans un premier chemin (2.1, 2.2, 3.1, 3.2, 4) pour la formation des signaux différentiels à partir de respectivement deux signaux de commande (U, V, W) modulés en largeur d'impulsion, dont les signaux de sortie sont amenés à des premiers filtres passe-bas (3.1, 3.2) avec une rotation de phase d'un angle d'environ -90°, de sorte que des signaux de sortie (V90, U90, W90) sont formés,
b) des seconds filtres passe-bas (10,1, 10.2, 10.3) de fréquence limite supérieure étant disposés dans un second chemin (10.1, 10.2, 10.3), auxquels des signaux de commande (U, V, W) modulés en largeur d'impulsion sont amenés, de sorte que d'autres signaux de sortie (U0, V0, W0) sont formés, et
c) un circuit de sélection sous forme d'un réseau de combinaison (21.1, 21.2, 21.3, 22.1, 22.2, 22.3) est prévu, auquel les signaux de sortie (U0, V0, W0, U90, V90, W90) du premier chemin et du second chemin sont amenés, et qui transmet les signaux de sortie d'un chemin en fonction de la différence entre les signaux de sortie (U0, V0, W0, U90, V90, W90) des deux chemins, le signal de sortie du premier chemin (2.1, 2.2, 3.1, 3.2, 4) étant transmis pour de petites différences et autrement le signal de sortie du second chemin (10.1, 10.2, 10.3) étant transmis.

7. Configuration de circuit selon la revendication 6, le premier filtre passe-bas (3.1, 3.2) étant un filtre passe-bas de premier ou de second ordre.

8. Configuration de circuit selon la revendication 6 ou 7, le second filtre passe-bas (10.1, 10.2, 10.3) présentant une fréquence limite sur la fréquence de la tension de réseau, afin d'obtenir une rotation de phase la plus faible possible.

9. Configuration de circuit selon la revendication 6, un autre filtre passe-bas étant monté en série avec le premier filtre passe-bas (3.1, 3.2) dans le premier chemin (2.1, 2.2, 3.1, 3.2, 4) et présentant une fréquence limite d'environ 0,5-2 kHz.

10. Configuration de circuit selon la revendication 6, le signal de sortie (U90, V90, W90) du premier chemin (2.1, 2.2, 3.1, 3.2, 4) étant amené à une résistance (21.1, 21.2, 21.3) dans le réseau de combinaison (21.1, 21.2, 21.3, 22.1, 22.2, 22.3) et ensuite à un point de sommation et le signal de sortie du second chemin (10.1, 10.2, 10.3) étant amené à un réseau de diodes (22.1, 22.2, 22.3) et ensuite au point de sommation.

11. Configuration de circuit selon la revendication 10, le réseau de diodes (22.1, 22.2, 22.3) présentant deux groupes montés en parallèle de diodes montées en série, de sorte que, en fonction du nombre des diodes montées en série, des signaux avec une amplitude de faible valeur ne sont pas transmis au point de sommation.
